# EUROPEAN PATENT SPECIFICATION

(11) **EP 4 261 622 B1**
(45) Date of publication and mention of the grant of the patent: **28.08.2024**
(21) Application number: 22213665.7
(22) Date of filing: 15.12.2022
(51) Int. Cl.: G04F 10/00

(54) **SYSTEM FOR RECOGNIZING ORDER OF SIGNALS**
SYSTEM ZUR ERKENNUNG DER REIHENFOLGE VON SIGNALEN
SYSTÈME DE RECONNAISSANCE D'ORDRE DE SIGNAUX

(30) Priority: 14.04.2022 PL 44094522
(43) Date of publication of application: 18.10.2023
(73) Proprietor: Akademia Gorniczo-Hutnicza im. Stanislawa Staszica w Krakowie, 30-059 Krakow (PL)
(72) Inventor: Koscielnik, Dariusz, 31-431 Kraków (PL); Szyduczynski, Jakub, 22-460 Szczebrzeszyn (PL); Miskowicz, Marek, 31-621 Kraków (PL); Jurasz, Konrad, 34-331 Swinna (PL)
(74) Representative: Wlasienko, Jozef

(56) References cited:
- ABAS M A ET AL: "Built-in time measurement circuits - a comparative design study", 20070305, vol. 1, no. 2, 5 March 2007 (2007-03-05), pages 87 - 97, XP006028356
- KOSCIELNIK DARIUSZ ET AL: "Optimized design of successive approximation time-to-digital converter with single set of delay lines", 2016 SECOND INTERNATIONAL CONFERENCE ON EVENT-BASED CONTROL, COMMUNICATION, AND SIGNAL PROCESSING (EBCCSP), IEEE, 13 June 2016 (2016-06-13), pages 1 - 8, XP032983233, DOI: 10.1109/EBCCSP.2016.7605284
- ABAS M A ET AL: "Embedded high-resolution delay measurement system using time amplification", 20070305, vol. 1, no. 2, 5 March 2007 (2007-03-05), pages 77 - 86, XP006028355

## Description

The subject of the invention is a system for recognizing an order of signals that can be applied in control and measurement systems and automation, but mainly in analog-to-digital conversion of the TDC type (time-to-digital conversion), in which the analog input quantity is a time interval. TDC converters of this type are used e.g. in: laser rangefinders, digital phase locked loops (DPLL), positron emission tomography and post-production tests of time parameters of very large-scale integration (VLSI) integrated circuits.

From the publication: M. A. Abas, G. Russell and D. J. Kinniment, "Design of Sub-10-Picoseconds On-Chip Time Measurement Circuit" a system for recognizing an order of signals is known, referred to as MUTEX (mutual exclusion). This system includes an asynchronous RS flip-flop and a filter of forbidden states that may appear on outputs of the RS flip-flop when it exhibits metastability. The MUTEX circuit is provided with a set input, a reset input, a first output, and a second output. The set input is connected to a first input of a first NAND logic gate, whose second input is connected to an output of a second NAND logic gate. An output of the first NAND gate is connected to a second input of the second NAND logic gate, whose first input is connected to the reset input of the MUTEX circuit. Both NAND logic gates, together with connections between them, form the asynchronous RS flip-flop. The output of the first NAND logic gate is furthermore connected to a gate of a first PMOS transistor and to a gate of a first NMOS transistor and to a source of a second PMOS transistor. The output of the second NAND logic gate is in turn connected to a gate of the second PMOS transistor and to a gate of a second NMOS transistor and to a source of the first PMOS transistor. A drain of the first PMOS transistor is connected to a drain of the first NMOS transistor and to the first output of the MUTEX circuit. A drain of the second PMOS transistor is connected to a drain of the second NMOS transistor and to the second output of the MUTEX circuit. Moreover, a source of the first NMOS transistor is connected to a source of the second NMOS transistor and to the system ground. All four MOS transistors, together with connections between them, form the forbidden state filter.

The presented structure of the MUTEX circuit is designed to work with signals whose active states are high logical states. There is also a variation of the MUTEX circuit, less frequently used in practice and designed to work with signals whose active states are low logical states. In such case both NAND logic gate are replaced with NOR logic gates, and the simple structure of the forbidden state filter is replaced with its inverted version.

From the publication: D. J. Kinniment, O. V. Maevsky, A. Bystrov, G. Russell and A. V. Yakovlev, "On-Chip structures for Timing Measurement and Test" a metastability effect of a MUTEX circuit is known. This metastability occurs in an asynchronous RS flip-flop when both inputs of the MUTEX circuit are put into their active states quasi-simultaneously. Outputs of a first logic gate and of a second logic gate are then introduced for a relatively long time into forbidden states. A forbidden state filter prevents these states from entering the outputs of the MUTEX circuit, keeping these exits still in inactive state. However, the use of the filter does not shorten the duration of metastability of the RS flip-flop in any way.

From the publication: M. A. Abas, G. Russell and D. J. Kinniment, "Built-in time measurement circuits - a comparative design study" IET Comput. Digit. Tech., 2007, 1, (2), pp. 87 - 97, a system of an analog-to-digital converter of the TDC type (time-to-digital conversion) is known that uses the successive approximation method, in which the coded analog quantity is a time interval. This interval is represented by a distance of time between the moments in which a source signal and a reference signal successively enter their active states. The converter system is composed of n sequentially connected cells, wherein n is at the same time a number of bits of an output digital word. Each of the cells comprises an input of a source signal and an input of a reference signal, and an output of a source path, connected to an input of a source signal of a possible next cell and an output of a reference path, connected to an input of a reference signal of a possible next cell. Each cell is furthermore provided with an output of a bit having index x of an n-bit output digital word, wherein the position of this bit having index x in the digital word corresponds to the position of a given cell in the structure of the converter system. Each of the cells comprises a MUTEX circuit, whose set input is connected to the input of the source signal of this cell, and whose reset input is connected to the input of the reference signal of the given cell. A first output of the MUTEX circuit is in turn connected to an output of bits of the considered cell. Moreover, the input of the source signal is connected to a first compensating delay circuit, and the input of the reference signal is connected to a second compensating delay circuit. Propagation times of the first and second compensating delay circuits are equal and larger than a nominal propagation time of the MUTEX circuit. An output of the first compensating delay circuit is connected to an input of a first equalizing delay circuit and to an output of a first reference delay circuit, integrated with a second equalizing delay circuit, whose output is connected to a first input of a first multiplexer. A second input of the first multiplexer is connected to an output of the first equalizing delay circuit. An output of the first multiplexer is connected to the output of the source path of a given cell. An address input of the first multiplexer is connected to the first output of the MUTEX circuit. An output of the second compensating delay circuit is connected to an input of a third equalizing delay circuit and to an input of a second reference delay circuit, integrated with a fourth equalizing delay circuit, whose output is connected to a first input of a second multiplexer. A second input of the second multiplexer is connected to an output of the third equalizing delay circuit. An output of the second multiplexer is connected to the output of the reference path of a given cell. An address input of the second multiplexer is connected to a second output of the MUTEX circuit. Propagation times of the first, second, third and fourth equalizing delay circuits are equal and larger than propagation times of the first and second multiplexers. Whereas propagation times of the first and second reference delay circuits are equal to each other and are two times shorter than propagation times of the reference delay circuits located in a cell directly preceding the given cell in the converter system. According to the present invention there is provided a system for recognizing an order of signals in accordance with claim 1. Preferred embodiments are defined in dependent claims 2 and 3.

A system for recognizing an order of signals, according to the invention, comprises, in a cell of an analog-to-digital converter used to determine a value of a bit having index x of an n-bit output digital word, a main MUTEX circuit provided with a set input connected to an input of a source signal, and a reset input connected to an input of a reference signal. The main MUTEX circuit is furthermore provided with a first output connected to a first control input of a path configuration circuit and a second output connected to a second control input of the path configuration circuit. The input of the source signal is additionally connected to an input of a first delay circuit, whose output is connected to an input of a source path of the path configuration circuit. The input of the reference signal is in turn connected to an input of a second delay circuit, whose output is connected to an input of a reference path of the path configuration circuit. Propagation time of the first delay circuit is equal to propagation time of the second delay circuit and longer than a nominal propagation delay of the main MUTEX circuit.

The essence of the solution lies in that the input of the source signal is connected to a first input of a first gate, whose second input is connected to the input of the reference signal. An output of the first gate is in turn connected to an input of an additional delay circuit, whose output is connected to a reset input of an additional MUTEX circuit. Propagation time of the additional delay circuit is shorter than the propagation time of the first delay circuit and simultaneously is longer than the nominal propagation delay of the main MUTEX circuit. Moreover, the first output of the main MUTEX circuit is connected to a data input of an output module and to a first input of a second gate, whose second input is connected to the second output of the main MUTEX circuit. An output of the second gate is in turn connected to a set input of the additional MUTEX circuit, whose second output is connected to a priority input of the output module equipped with outputs of bits of the n-bit output digital word.

It is advantageous if the first gate and the second gate are OR logic gates and simultaneously the main MUTEX circuit and the additional MUTEX circuit comprise asynchronous RS flip-flops composed of NAND logic gates and simple filters.

It is also advantageous if the first gate and the second gate are AND logic gates and simultaneously the main MUTEX circuit and the additional MUTEX circuit comprise asynchronous RS flip-flops composed of NOR logic gates and inverted filters.

The advantage of the solution lies in ensuring the correct operation of the TDC-type analog-to-digital converter even in a situation where metastability of the MUTEX circuit occurs at any stage of processing. In such a situation, to all bits of this part of the output digital word which due to metastability of the MUTEX circuit is at risk of being falsified, a predetermined default value will be assigned. The final value of the output digital word obtained in this way differs by at most one from the result that could be obtained in an ideal, completely metastability-free converter.

The solution also allows to interrupt the analog-to-digital conversion process, during which metastability of the MUTEX circuit occurred. In this way both the time and the amount of energy necessary to obtain the correct processing result are reduced.

The subject of the invention is explained in exemplary embodiments in the drawing which shows:
- Fig. 1 -: a diagram of a system for recognizing an order of signals.
- Fig. 2 -: a diagram of a MUTEX circuit reacting to an active state in the form of a logical high state, containing an asynchronous RS flip-flop composed of NAND logic gates and a simple filter.

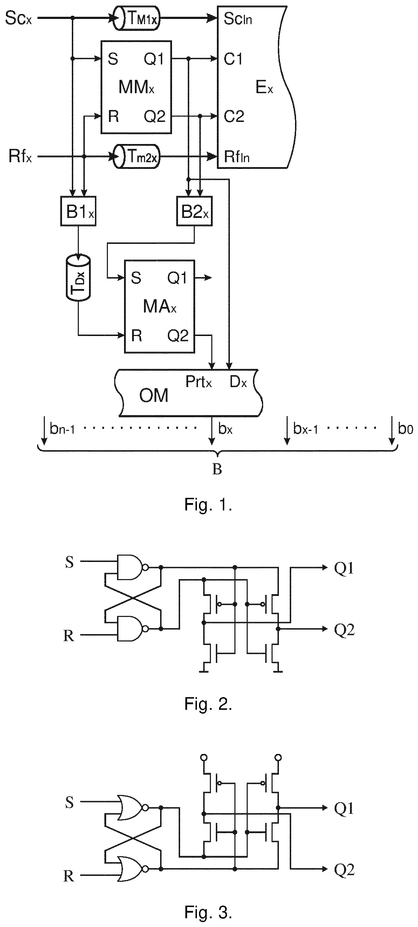

- Fig. 2 -: a diagram of a MUTEX circuit reacting to an active state in the form of a logical low state, containing an asynchronous RS flip-flop composed of NOR logic gates and an inverted filter.

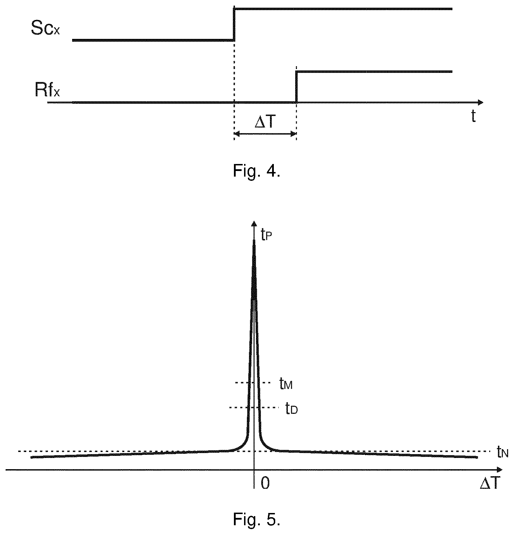

- Fig. 4 -: a time interval ΔT separating moments of entering active states by a source signal Scₓ and by a reference signal Rfₓ.
- Fig. 5 -: a propagation delay t_{P} of the main MUTEX circuit MMₓ as a function of time interval ΔT.

According to the invention, a system for recognizing an order of signals, in a first exemplary solution (fig. 1), in a cell of an analog-to-digital converter, used to determine a value of a bit having index x, bₓ, of an n-bit output digital word B, comprises a main MUTEX circuit MMₓ. The main MUTEX circuit MMₓ is provided with a set input S, a reset input R, a first output Q1 and a second output Q2. The set input S of the main MUTEX circuit MMₓ is connected to an input of a source signal Scₓ, and the reset input R of the main MUTEX circuit MMₓ is connected to an input of a reference signal Rfₓ. The first output Q1 of the main MUTEX circuit MMₓ is connected to a first control input C1 of a path configuration circuit Eₓ, whereas the second output Q2 of the main MUTEX circuit MMₓ is connected to a second control input C2 of the path configuration circuit Eₓ. The input of the source signal Scₓ is furthermore connected to an input of a first delay circuit T_{M1x}, whose output is connected to an input of a source path Sc_{In} of the path configuration circuit Eₓ. On the other hand, the input of the reference signal Rfₓ is connected to an input of a second delay circuit T_{M2x}, whose output is connected to an input of a reference path Rf_{In} of the path configuration circuit Eₓ. Propagation time t_{M} of the first delay circuit T_{M1x} is equal to propagation time t_{M} of the second delay circuit T_{M2x} and is five times longer than a nominal propagation delay t_{N} of the main MUTEX circuit MMₓ. The input of the source signal Scₓ is connected to a first input of a first gate B1ₓ, whose second input is connected to the input of the reference signal Rfₓ. An output of the first gate B1ₓ is in turn connected to an input of an additional delay circuit T_{Dx}, whose output is connected to a reset input R of an additional MUTEX circuit MAₓ. Propagation time to of the additional delay circuit T_{Dx} is four times longer than the nominal propagation delay t_{N} of the main MUTEX circuit MMₓ and is shorter than the propagation time t_{M} of the first delay circuit T_{M1x} and of the second delay circuit T_{M2x}. In this exemplary system the main MUTEX circuit MMₓ and the additional MUTEX circuit MAₓ are known MUTEX circuits including asynchronous RS flip-flops composed of NAND logic gates and simple filters (fig.2). The first output Q1 of the main MUTEX circuit MMₓ is connected to a data input Dₓ of an output module OM and to a first input of a second gate B2ₓ, whose second input is connected to the second output Q2 of the main MUTEX circuit MMₓ. An output of the second gate B2ₓ is in turn connected to a set input S of the additional MUTEX circuit MAₓ, whose second output Q2 is connected to a priority input Prtₓ of the output module OM. The output module OM is furthermore provided with outputs of bits bₙ₋₁, ..., b₀ of the n-bit output digital word B. In this exemplary system, the first gate B1ₓ and the second gate B2ₓ are OR logic gates.

In a second exemplary solution, the system for recognizing an order of signals according to the invention differs from the first one in that the main MUTEX circuit MMₓ and the additional MUTEX circuit MAₓ are known MUTEX circuits including asynchronous RS flip-flops composed of NOR logic gates and inverted filters (fig. 3). Moreover, in this exemplary solution, the first gate B1ₓ and the second gate B2ₓ are AND logic gates.

Recognition of an order of signals implemented, according to the invention, in the first exemplary system (fig. 1) proceeds as follows. The MUTEX circuit indicates, as the leading signal, the signal which enters its active state earlier. It happens so, however, provided that both signals do not enter their active states quasi-simultaneously. The first of the considered signals is the source signal Scₓ, and the second is the reference signal Rfₓ. In the first exemplary system the active state is a logical high state.

In the case where the source signal Scₓ and the reference signal Rfₓ do not enter their active states quasi-simultaneously, a time interval ΔT separating activation moments of these signals (fig. 4) has little effect on length of a propagation delay t_{P} (fig. 5) with which the main MUTEX circuit MMₓ reacts on the appearance of the leading signal by activating one of its two outputs. The propagation delay of the main MUTEX circuit MMₓ in such case is equal or slightly larger than the nominal propagation delay t_{N} of the main MUTEX circuit MMₓ (fig. 5) and is shorter than the propagation time to of the additional delay circuit T_{Dx} (fig. 5). If the leading signal is the source signal Scₓ, then the first output Q1 of the main MUTEX circuit MMₓ will be put into active state. If, however, the leading signal is the reference signal Rfₓ, then the second output Q2 of the main MUTEX circuit MMₓ will be put into active state. Later entering active state by the second of the signals has no influence on the already established state of the outputs of the main MUTEX circuit MMₓ. In the case where the leading signal is the source signal Scₓ, the active state of the first output Q1 of the main MUTEX circuit MMₓ, fed to the first control input C1 of the path configuration circuit Eₓ causes a reference delay, having length suitable for a given analog-to-digital converter cell, to be included in a path of the source signal Scₓ. Simultaneously, a path of the reference signal Rfₓ will not include the reference delay. Otherwise, when the leading signal is the reference signal Rfₓ, the active state of the second output Q2 of the main MUTEX circuit MMₓ, fed to the second control input C2 of the path configuration circuit Eₓ, causes the reference delay to be included in the path of the reference signal Rfₓ. Simultaneously, the path of the source signal SCₓ will not include the reference delay. The source signal Scₓ and the reference signal Rfₓ are fed to, respectively, the input of the source path Sc_{In} of the path configuration circuit Eₓ and the input of the reference path Rf_{In} of the path configuration circuit Eₓ through the first delay circuit T_{M1x} and the second delay circuit T_{M2x}, respectively. In the considered case the propagation delay t_{P} of the main MUTEX circuit MMₓ is shorter than the propagation times t_{M} of the first delay circuit T_{M1x} and of the second delay circuit T_{M2x} (fig. 5). Therefore, each of the signals reaches the input of its own path in the path configuration circuit Eₓ only when both paths have been previously properly configured, what is necessary for proper operation of the analog-to-digital converter.

The length of the propagation delay t_{P} of the main MUTEX circuit MMₓ is always controlled by means of the additional MUTEX circuit MAₓ. The beginning of an interval of the propagation delay t_{P} of the main MUTEX circuit MMₓ is indicated by means of the first gate B1ₓ, whose output enters active state as a result of the appearance of the leading signal at either of the two inputs of this gate. An output signal of the first gate B1ₓ is delayed by means of the additional delay circuit T_{Dx} and eventually reaches the reset input R of the additional MUTEX circuit MAₓ. The end of the interval of the propagation delay t_{P} of the main MUTEX circuit MMₓ is indicated by means of the second gate B2ₓ, whose output enters active state as a result of the appearance of the active state at either of the two outputs of the main MUTEX circuit MMₓ. An output signal of the second gate B2ₓ is fed to the set input S of the additional MUTEX circuit MAₓ. Propagation delays of the first gate B1ₓ and of the second gate B2ₓ are identical and compensate each other. The propagation delay t_{P} of the main MUTEX circuit MMₓ is in turn, in the considered case, shorter than the propagation time to of the additional delay circuit T_{Dx} (fig. 5). Therefore, the set input S of the additional MUTEX circuit MAₓ will be put into active state first. Thereby, the active state will eventually appear on an unused first output Q1 of the additional MUTEX circuit MAₓ. The second output Q2 of the additional MUTEX circuit MAₓ will remain in inactive state also when the active state of the additional delay circuit T_{Dx} eventually reaches the reset input R of the additional MUTEX circuit MAₓ. Thereby the priority input Prtₓ of the output module OM will be constantly kept in inactive state and will not affect in any way the value given to the bit bₓ by the output module OM. The value of this bit will be only influenced by the state of the first output Q1 of the main MUTEX circuit MMₓ, fed to the data input Dₓ of the output module OM. If the data input Dₓ of the output module OM is in inactive state, then a logical state zero is assigned to the bit bₓ by means of the output module OM. Otherwise, when the data input Dₓ of the output module OM is in active state, a logical state one is assigned to the bit bₓ by means of the output module OM.

In the case where the source signal Scₓ and the reference signal Rfₓ enter their active states quasi-simultaneously, the main MUTEX circuit MMₓ exhibits metastability. The propagation delay t_{P} of the main MUTEX circuit MMₓ rapidly increases (fig. 5) and becomes longer than the propagation time to of the additional delay circuit T_{Dx}. The propagation delay t_{P} of the main MUTEX circuit MMₓ may then become longer than the propagation time t_{M} of the first delay circuit T_{M1x} and of the second delay circuit T_{M2x} (fig. 5). In such case the source signal Scₓ and the reference signal Rfₓ reach the input of the source path Sc_{In} of the path configuration circuit Eₓ and the input of the reference path Rf_{In} of the path configuration circuit Eₓ, respectively, even before the active state appears on one of the outputs of the main MUTEX circuit MMₓ. Quasi-simultaneous: the source signal Scₓ and the reference signal Rfₓ therefore propagate through paths which have not yet been properly configured by means of the path configuration circuit Eₓ. Analog-to-digital conversion algorithm of the successive approximation method does not anticipate such a situation, and its occurrence causes falsification of the correct value of the determined output digital word B. At the same time, however, quasi-simultaneity of the source signal Scₓ and of the reference signal Rfₓ means that in the previously performed steps of processing the positions of both signals have been already managed to align in the time domain, in addition, with an accuracy better than the resolution of a given converter. This situation can only occur when the measured time interval ΔT was initially quasi-equal to 1/2 of the processing range, or 1/4 of the processing range, or 3/4 of the processing range, or 1/8 of the processing range, etc.

So if the ideal analog-to-digital converter in which the main MUTEX circuit MMₓ is completely free of metastability, encountered quasi-simultaneity of the source signal Scₓ and of the reference signal Rfₓ in a processing step used to determine the bit having index x bₓ, then such a converter in this processing step would include the reference delay in a path of one of the signals, and in each of subsequent processing steps it would include the reference delays of twice decreasing lengths in a path of the second of the signals, trying to realign the positions of these signals in time domain. Therefore it is certain that in the output digital word B of the ideal analog-to-digital converter, values of the bit bₓ and of all possible less significant bits bₓ₋₁, ..., b₀ must take one of two sequences: 0, 1, 1, ..., 1 or 1, 0, 0, ..., 0. Moreover, in case the source signal Scₓ and the reference signal Rfₓ enter their active state simultaneously, both of the above sequences are equally likely. In the considered case, the result of analog-to-digital conversion can therefore be predicted with an accuracy to one, without carrying out the remaining steps of this process or omitting their results, which will turn out to be falsified for the real converter anyway due to metastability of the MUTEX circuit.

The metastability of the main MUTEX circuit MMₓ is detected and signaled by means of the additional MUTEX circuit MAₓ. In the considered case the propagation delay t_{P} of the main MUTEX circuit MMₓ is longer than the propagation time t_{M} of the additional delay circuit T_{Dx} (fig. 5). Therefore, the reset input R of the additional MUTEX circuit MAₓ will be put into active state first. Thereby, the active state will appear on the second output Q2 of the additional MUTEX circuit MAₓ and will be forwarded to the priority input Prtₓ of the output module OM, signaling the metastability of the main MUTEX circuit MMₓ to the output module OM. As a result of the above, the output module OM will immediately assign default values to the bit bₓ and to all possible less significant bits bₓ₋₁, ..., b₀ of the output digital word B. Moreover, starting from this point of time, the output module OM will ignore the state of its data input Dₓ, both at that processing stage and at any subsequent processing stage. The output module OM will therefore assign a logical state zero to the bit bₓ, and the output module OM will assign logical states one to all possible less significant bits bₓ₋₁, ..., b₀ of the output digital word B. The final value of the output digital word B will be equal to or one less than the value of the output digital word B, which would be obtained in an ideal analog-to-digital converter. In another exemplary solution, the output module OM will assign a logical state one to the bit bₓ, and the output module OM will assign logical states zero to all possible less significant bits bₓ₋₁, ..., b₀ of the output digital word B. In this solution, the final value of the output digital word B will therefore be equal to or one greater than the value of the output digital word B, which would be obtained in an ideal analog-to-digital converter.

In a particular case the propagation delay t_{P} of the main MUTEX circuit MMₓ is quasi-equal to the propagation time to of the additional delay circuit T_{Dx} (fig. 5). The propagation delay t_{P} of the main MUTEX circuit MMₓ is therefore shorter than the propagation times t_{M} of the first delay circuit T_{M1x} and the second delay circuit T_{M2x} (fig. 5). Therefore, the source signal Scₓ and the reference signal Rfₓ reach the input of the source path Sc_{In} of the path configuration circuit Eₓ and the input of the reference path Rf_{In} of the path configuration circuit Eₓ, respectively, only when the main MUTEX circuit MMₓ has already put the appropriate control input of the path configuration circuit Eₓ into the active state. The source signal Scₓ and the reference signal Rfₓ therefore propagate through paths configured properly and in advance as required. So the analog-to-digital conversion process is working properly, and the output module OM can use the state of the first output Q1 of the main MUTEX circuit MMₓ to assign the appropriate value to the bit having index x, bₓ, of the output digital word B.

As in any case, the length of the propagation delay t_{P} of the main MUTEX circuit MMₓ is controlled by means of the additional MUTEX circuit MAₓ. In the particular case under consideration, the propagation delay t_{P} of the main MUTEX circuit MMₓ is quasi-equal to the propagation time to of the additional delay circuit T_{Dx} (fig. 5). Therefore, the set input S of the additional MUTEX circuit MAₓ and the reset input R of the additional MUTEX circuit MAₓ are put into their active states quasi-simultaneously, causing metastability of the additional MUTEX circuit MAₓ. The result of it is a significant extension of the propagation delay of the additional MUTEX circuit MAₓ and the inability to unambiguously indicate the output of the additional MUTEX circuit MAₓ, which will eventually be put into active state. If the active state appears on the unused first output Q1 of the additional MUTEX circuit MAₓ, the priority input Prtₓ of the output module OM will still be kept in inactive state by means of the second output Q2 of the additional MUTEX circuit MAₓ. The values of the bit having index x, bₓ, and of a part of possible less significant bits bₓ₋₁, bₓ₋₂, ..., of the output digital word B, already determined as a result of the analog-to-digital conversion process, which is still running correctly, will therefore be kept. If, however, the active state eventually appears on the second output Q2 of the additional MUTEX circuit MAₓ, then the priority input Prtₓ of the output module OM will be put into active state, signaling potential metastability of the main MUTEX circuit MMₓ to the output module OM. As a result of the above, the output module OM will assign default values to the bit bₓ and to all possible less significant bits bₓ₋₁, ..., b₀ of the output digital word B. Moreover, the output module OM will ignore the state of its data input Dₓ, both at that processing stage and at any subsequent processing stage. The output module OM will therefore assign a logical state zero to the bit bₓ, and the output module OM will assign logical states one to all possible less significant bits bₓ₋₁, ..., b₀ of the output digital word B. The value of the output digital word B obtained in this way will be equal to or one less than the value of the output digital word B, that would be obtained by continuing the normal analog-to-digital conversion process. In another exemplary solution, the output module OM will assign a logical state one to the bit bₓ, and the output module OM will assign logical states zero to all possible less significant bits bₓ₋₁, ..., b₀ of the output digital word B. In this solution, the final value of the output digital word B will therefore be equal to or one greater than the value of the output digital word B, that would be obtained by continuing the normal analog-to-digital conversion process.

Recognition of an order of signals implemented, according to the invention, in the second exemplary system proceeds in an identical manner as in the first exemplary system (fig. 1), with the only difference that the active state is a logical low state.

## Claims

1. A system for recognizing an order of signals, including in a cell of an analog-to-digital converter, used to determine a value of a bit having index x of an n-bit output digital word, a main MUTEX circuit provided with a set input connected to an input of a source signal and a reset input connected to an input of a reference signal and a first output connected to a first control input of a path configuration circuit and a second output connected to a second control input of the path configuration circuit, and furthermore the input of the source signal is connected to an input of a first delay circuit, whose output is connected to an input of a source path of the path configuration circuit, whereas the input of the reference signal is connected to an input of a second delay circuit, whose output is connected to an input of a reference path of the path configuration circuit, wherein propagation time of the first delay circuit is equal to propagation time of the second delay circuit and longer than nominal propagation delay of the main MUTEX circuit, **characterized in that** the input of the source signal (Scₓ) is connected to a first input of a first gate (B1ₓ), whose second input is connected to the input of the reference signal (Rfₓ), whereas an output of the first gate (B1ₓ) is connected to an input of an additional delay circuit (T_{Dx}), whose output is connected to a reset input (R) of an additional MUTEX circuit (MAₓ), wherein propagation time (to) of the additional delay circuit (T_{Dx}) is shorter than the propagation time (t_{M}) of the first delay circuit (T_{M1x}) and at the same time longer than the nominal propagation delay (t_{N}) of the main MUTEX circuit (MMₓ), and the first output (Q1) of the main MUTEX circuit (MMₓ) is connected to a data input (Dₓ) of an output module (OM) and to a first input of a second gate (B2ₓ), whose second input is connected to the second output (Q2) of the main MUTEX circuit (MMₓ), whereas an output of the second gate (B2ₓ) is connected to a set input (S) of the additional MUTEX circuit (MAₓ), whose second output (Q2) is connected to a priority input (Prtₓ) of the output module (OM) equipped with outputs of bits (bₙ₋₁, ..., b₀) of the n-bit output digital word (B).

2. The system according to claim 1, **characterized in that** the first gate (B1ₓ) and the second gate (B2ₓ) are OR logic gates and simultaneously the main MUTEX circuit (MMₓ) and the additional MUTEX circuit (MAₓ) comprise asynchronous RS flip-flops composed of NAND logic gates and simple filters.

3. The system according to claim 1, **characterized in that** the first gate (B1ₓ) and the second gate (B2ₓ) are AND logic gates and simultaneously the main MUTEX circuit (MMₓ) and the additional MUTEX circuit (MAₓ) comprise asynchronous RS flip-flops composed of NOR logic gates and inverted filters.

## Patentansprüche

1. System zum Erkennen einer Signalreihenfolge, das in einer Zelle eines Analog-Digital-Umsetzers, die zum Bestimmen eines Werts eines Bits mit Index x eines n-Bit-Ausgangsdigitalworts verwendet wird, eine Haupt-MUTEX-Schaltung enthält, die mit einem mit einem Eingang eines Quellsignals verbundenen Setzeingang, einem mit einem Eingang eines Referenzsignals verbundenen Rücksetzeingang, und einem mit einem ersten Steuereingang einer Pfadkonfigurationsschaltung verbundenen ersten Ausgang, und einem mit einem zweiten Steuereingang der Pfadkonfigurationsschaltung verbundenen zweiten Ausgang ausgestattet ist, und außerdem der Eingang des Quellsignals mit einem Eingang einer ersten Verzögerungsschaltung verbunden ist, deren Ausgang mit einem Eingang eines Quellpfads der Pfadkonfigurationsschaltung verbunden ist, während der Eingang des Referenzsignals mit einem Eingang einer zweiten Verzögerungsschaltung verbunden ist, deren Ausgang mit einem Eingang eines Referenzpfads der Pfadkonfigurationsschaltung verbunden ist, wobei die Ausbreitungszeit der ersten Verzögerungsschaltung gleich der Ausbreitungszeit der zweiten Verzögerungsschaltung ist, und länger als die nominale Ausbreitungsverzögerung der Haupt-MUTEX-Schaltung ist, **dadurch gekennzeichnet, dass** der Eingang des Quellsignals (Scₓ) mit einem ersten Eingang eines ersten Gatters (B1ₓ) verbunden ist, dessen zweiter Eingang mit dem Eingang des Referenzsignals (Rfₓ) verbunden ist, während ein Ausgang des ersten Gatters (B₁ₓ) mit einem Eingang einer zusätzlichen Verzögerungsschaltung (T_{Dx}) verbunden ist, deren Ausgang mit einem Rücksetzeingang (R) einer zusätzlichen MUTEX-Schaltung (MAₓ) verbunden ist, wobei die Ausbreitungszeit (t_{D}) der zusätzlichen Verzögerungsschaltung (T_{Dx}) kürzer als die Ausbreitungszeit (t_{M}) der ersten Verzögerungsschaltung (T_{M1x}) und gleichzeitig länger als die nominale Ausbreitungsverzögerung (t_{N}) der Haupt-MUTEX-Schaltung (MMₓ) ist, und der erste Ausgang (Q1) der Haupt-MUTEX-Schaltung (MMₓ) mit einem Dateneingang (Dₓ) eines Ausgabemoduls (OM) und mit einem ersten Eingang eines zweiten Gatters (B2ₓ) verbunden ist, dessen zweiter Eingang mit dem zweiten Ausgang (Q2) der Haupt-MUTEX-Schaltung (MMₓ) verbunden ist, während ein Ausgang des zweiten Gatters (B2ₓ) mit einem Setzeingang (S) der zusätzlichen MUTEX-Schaltung (MAₓ) verbunden ist, dessen zweiter Ausgang (Q2) mit einem Prioritätseingang (Prtₓ) des Ausgabemoduls (OM) verbunden ist, das mit Ausgängen von Bits (bₙ₋₁, ..., b₀) des n-Bit-Ausgangsdigitalworts (B) ausgestattet ist.

2. System gemäß Anspruch 1, **dadurch gekennzeichnet, dass** das erste Gatter (B1ₓ) und das zweite Gatter (B2ₓ) OR-Logikgatter sind und gleichzeitig die Haupt-MUTEX-Schaltung (MMₓ) und die zusätzliche MUTEX-Schaltung (MAₓ) asynchrone, aus NAND-Logikgattern ausgebaute RS-Flipflops und einfache Filter enthalten.

3. System gemäß Anspruch 1, **dadurch gekennzeichnet, dass** das erste Gatter (B1ₓ) und das zweite Gatter (B2ₓ) AND-Logikgatter sind und gleichzeitig die Haupt-MUTEX-Schaltung (MMₓ) und die zusätzliche MUTEX-Schaltung (MAₓ) asynchrone, aus NOR-Logikgattern ausgebaute RS-Flipflops und invertierte Filter enthalten.

## Revendications

1. Système de reconnaissance d'un ordre de signaux, qui dans une cellule d'un convertisseur analogique-numérique, pour déterminer une valeur d'un bit ayant l'indice x d'un mot numérique de sortie de n bits, contient un circuit MUTEX principal équipé d'une entrée de réglage connectée à une entrée d'un signal de source et une entrée de réinitialisation connectée à une entrée d'un signal de référence et une première sortie connectée à une première entrée de commande d'un circuit de configuration de trajet et une deuxième sortie connectée à une deuxième entrée de commande du circuit de configuration de trajet, et en outre l'entrée du signal de source est connectée à une entrée d'un premier circuit à retard, dont la sortie est connectée à une entrée d'un trajet de source du circuit de configuration de trajet, tandis que l'entrée du signal de référence est connectée à une entrée d'un deuxième circuit à retard, dont la sortie est connectée à une entrée d'un trajet de référence du circuit de configuration de trajet, le temps de propagation du premier circuit à retard étant égal au temps de propagation du deuxième circuit à retard et plus long que retard de propagation nominal du circuit MUTEX principal, **caractérisé en ce que** l'entrée du signal de source (Scₓ) est connectée à une première entrée d'une première porte (B1ₓ), dont la deuxième entrée est connectée à l'entrée du signal de référence (Rfₓ), tandis qu'une sortie de la première porte (B1ₓ) est connectée à l'entrée d'un circuit à retard supplémentaire (T_{Dx}), dont la sortie est connectée à une entrée de réinitialisation (R) du circuit MUTEX supplémentaire (MAₓ), dans lequel le temps de propagation (t_{D}) du circuit à retard supplémentaire (T_{Dx}) est plus court que le temps de propagation (t_{M}) du premier circuit à retard (T_{M1x}) et en même temps est plus long que le retard de propagation nominal (t_{N}) du circuit MUTEX principal (MMₓ), et la première sortie (Q1) du circuit MUTEX principal (MMₓ) est connectée à une entrée des données (Dₓ) d'un module de sortie (OM) et à une première entrée d'une deuxième porte (B2ₓ), dont la deuxième entrée est connectée à la deuxième sortie (Q2) du circuit MUTEX principal (MMₓ), tandis qu'une sortie de la deuxième porte (B2ₓ) est connectée à une entrée de réglage (S) du circuit MUTEX supplémentaire (MAₓ), dont la deuxième sortie (Q2) est connectée à une entrée prioritaire (Prtₓ) du module de sortie (OM) équipé de sorties de bits (bₙ₋₁, ..., b₀) du mot numérique de sortie (B) de n bits.

2. Système selon la revendication 1, **caractérisé en ce que** la première porte (B1ₓ) et la deuxième porte (B2ₓ) sont des portes logiques OR et simultanément le circuit MUTEX principal (MMₓ) et le circuit MUTEX supplémentaire (MAₓ) comprennent des bascules RS flip-flops asynchrones composés de portes logiques NAND et des filtres simples.

3. Système selon la revendication 1, **caractérisé en ce que** la première porte (B1ₓ) et la deuxième porte (B2ₓ) sont des portes logiques AND et simultanément le circuit MUTEX principal (MMₓ) et le circuit MUTEX supplémentaire (MAₓ) comprennent des bascules RS flip-flops asynchrones composés de portes logiques NOR et des filtres inversés.
